Europäisches Patentamt

**(19)** European Patent Office

Office européen des brevets

(11) Publication number : **0 285 413 B1**

(12) **EUROPEAN PATENT SPECIFICATION**

(45) Date of publication of patent specification :
06.09.95 Bulletin 95/36

(51) Int. Cl.⁶ : **H03H 17/06**

(21) Application number : **88302877.1**

(22) Date of filing : **30.03.88**

(54) **Sample rate converter.**

(30) Priority : **30.03.87 US 32165**

(43) Date of publication of application :
**05.10.88 Bulletin 88/40**

(45) Publication of the grant of the patent :
**06.09.95 Bulletin 95/36**

(84) Designated Contracting States :
**BE CH FR GB LI NL SE**

(56) References cited :
**EP-A- 0 137 323**
**US-A- 4 453 259**
**IEEE TRANSACTIONS ON CIRCUITS AND**
**SYSTEMS, vol. CAS-77, no. 2, February 1975,**
**pp. 145-154, New York, US; H. URKOWITZ:**
**"Parallel realizations of digital interpolation**
**filters for increasing the sampling rate"**

(56) References cited :
**IEEE TRANSACTIONS ON ACOUSTICS,**
**SPEECH, AND SIGNAL PROCESSING, vol.**
**ASSP-32, no. 3, June 1984, pp. 577-591, IEEE,**
**New York, US; T.A. RAMSTAD: "Digital**
**methods for conversion between arbitrary**
**sampling frequencies"**

(73) Proprietor : **CODEX CORPORATION**
**20 Cabot Boulevard**
**Mansfield, Massachusetts 02048 (US)**

(72) Inventor : **Qureshi, Shahid U.H.**
**24 Indian Ridge Road**
**Natick Massachusetts 01760 (US)**
Inventor : **Ling, Fuyun**
**202 Chestnut Lane**
**Jamaica Plain Massachusetts 02130 (US)**

(74) Representative : **Hudson, Peter David et al**
**Motorola**
**European Intellectual Property**
**Midpoint**
**Alencon Link**
**Basingstoke, Hampshire RG21 1PL (GB)**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to converting a stream of signal samples appearing at one sample rate into a stream of signal samples that carry the same information but appear at a different sample rate.

In modems used for full duplex communication over a two-wire voice-band telephone line, for example, the process of echo cancellation requires sampling the line signal at a first sampling rate that is related to (typically a multiple of) the local transmitter's baud rate. The sample stream is then subjected to echo cancellation by subtracting a sample stream (appearing at the same first sampling rate) that represents echo and leakage versions of the locally transmitted signal.

For decoding, however, the echo cancelled sample stream must be converted to a new sample stream that carries the same information but appears at a second sampling rate that is related to (typically a multiple of) the remote transmitter's baud rate. Commonly the remote and local transmitter baud rates are nominally the same but actually differ slightly.

It is known to accomplish sample rate conversion in the analog domain by converting the echo cancellation signal to analog, subtracting it from the analog received line signal, then reconverting the result to the digital domain at the desired second sampling rate, for decoding.

Alternatively, the echo cancellation may proceed in the digital domain (at the first sampling rate). The digital result is then converted to analog and reconverted to digital (at the second sampling rate).

It is well known that if an analog signal is sampled at a sufficiently high rate, the resulting samples will contain enough information to permit the original signal to be reconstructed perfectly. It is also known that by passing the samples through a transversal filter having a properly chosen set of coefficients, a new sample stream can be generated such that the new sample stream appears at any desired sample rate and, like the original sample stream, accurately represents the information in the original analog signal.

Miller, U.S. Patent 4,453,259, shows a modem in which samples of the line signal appearing at a first fixed rate are passed through an interpolation filter to generate a revised sample stream at a second rate. By selecting an appropriate one of several sets of filter coefficients, the second sample rate can be made to be any one of several different rate.

Weinstein, U.S. Patent 4,131, 767, shows an echo cancellation digital modem for full duplex communication in which the line signal is ampled at the Nyquist rate, then echo cancelled, and then resampled at the baud rate. One technique suggested for accomplishing the resampling is an "interpolation formula".

According to a first aspect of the present invention, we provide apparatus adapted to receive an input stream of samples representative of a time-varying signal and to generate a corresponding output stream of samples which is also representative of said time-varying signal and in which each output stream sample appears at a desired time which may differ from the time when a sample appears in said input stream, the apparatus being characterised in comprising filter circuitry adapted to receive said input stream and operatively to generate at least two intermediate samples which appear at different times, and interpolation circuitry adapted to combine selected said intermediate samples to form a sample of said output stream at said desired time.

The input sample stream is operatively sampled based on a clock derived from an unstable clock having a nominally fixed rate subject to jitter and frequency shifts. Thus the input stream operatively appears at a nominally fixed rate, and the intermediate samples are adapted operatively to be selected and the interpolation circuitry is adapted operatively to be controlled in response to the difference between the sampling phase of the input stream and the sampling phase of the output stream. The apparatus includes an arrangement for reducing the jitter and frequency shifts in the unstable clock.

In a second and alternative aspect of the invention, there is provided a modem in which a line signal is arranged operatively to be sampled at times governed by an unstable clock, whereby operatively to generate a first sample stream in which the samples appear with possibly changing sampling phases, and in which a converter is arranged operatively to convert the first sample stream to a second stream of samples appearing at times that are possibly different from the times of appearance of the samples in the first sample stream, characterized in comprising a signal arrangement adapted for operatively providing to the converter signals representative of the changing sampling phases in the first sample stream whereby operatively to cause the conversion to occur in a manner that reduces the contribution of the changing sampling phases to the times of appearance of the samples in the second sample stream utilizing a dynamic interpolation scheme.

In a third and equally alternative aspect thereof, the invention provides a method for generating an output stream of samples from an input stream of sample representative of a time-varying signal, the output stream of samples also being representative of said time-varying signal, and each output stream sample appearing at a desired time which may differ from the time when a sample appears in the input stream, the method being characterized in comprising the steps of receiving the input stream and generating, by filtering, at least two intermediate samples which appear at different times, and interpolating the selected intermediate samples to form a sample of the output stream at the desired time.

The invention provides in a forth and yet further alternative aspect thereof, a method of operating a modem in which a line signal is sampled at times governed by an unstable clock to generate a first sample stream in which the samples appear with possibly changing phases and a converter converts the first sampled stream to a second stream of samples appearing at times that are possibly different from the times of appearance to the samples in the first sample stream, the method being characterized in comprising providing to the converter signals representative of the changing sampling phases of the samples in the first sample stream, whereby to cause the conversion to occur in a manner that reduces the contribution of the changing sampling phases to the times of appearance of the samples in the second sample stream utilizing a dynamic interpolation scheme.

The invention is hereinafter more particularly describes by way of example only with reference to and as shown in the accompanying drawings, in which:-

FIG. 1 is a block diagram of a duplex communications system using echo cancellation modems;

Fig. 2 is a diagram of input and output samples of the sample rate converter of Fig. 1;

Fig. 3 is a block diagram of the sample rate converter; and

Fig. 4 is a block diagram including phase tracker and queue monitor circuitry.

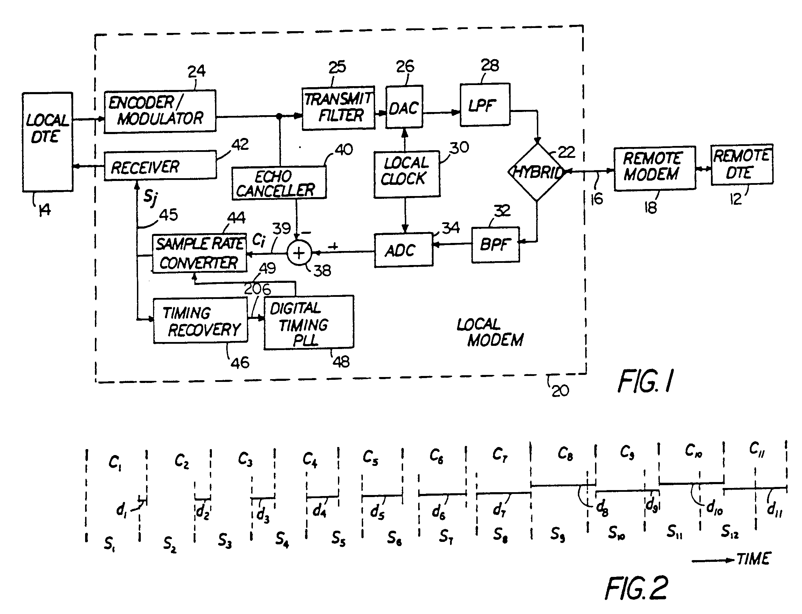

Referring to Fig. 1, in a full duplex communication system 10, data messages are carried simultaneously in both directions between a remote data terminal equipment (DTE 12) and a local DTE 14 over a two-wire telephone line 16. A message is passed over the line from DTE 14 to DTE 12 by modulating a carrier signal (e.g., by conventional quadrature amplitude modulation) in a succession of baud intervals (each $L_x$ long) in accordance with a series of symbols (appearing at the local transmission baud rate of $l/L_x$) that represent the message. Transmission from remote DTE 12 occurs at a possibly different baud rate of $l/R_x$. Modulation and demodulation of the carrier is done by a remote modem 18 associated with the remote DTE 12, and by a local modem 20 for local DTE 14. (Because remote modem 18 is similar to local modem 20 only local modem 20 is described below.)

Modem 20 includes a conventional hybrid 22 that both passes the modulated transmission carrier onto line 16 and continually detects the signal present on line 16 (that signal includes components related to both modulated carriers originating at both ends of line 16).

The local modulated transmission carrier originates at a conventional digital QAM encoder/modulator 24 which generates a series of encoded and modulated complex-valued symbols. The symbols are passed through a transmit filter 25 to generate real valued samples which are converted to an analog signal in digital-to-analog converter (DAC) 26, and then passed via a conventional low-pass filter 28 to hybrid 22. The output of transmit filter 25 comprises a sequence of digital samples appearing at a first sampling rate which is some integer value N times the local transmission symbol rate ($l/L_x$) (N is chosen so that $N/L_x$ is above the Nyquist sampling rate). DAC 26 is clocked to accept the values at that same rate by a local clock 30 (described below).

The analog line signal detected by hybrid 22 is passed via a conventional bandpass filter 32 to an analog-to-digital converter (ADC) 34 which samples it at rate $N/L_x$. The clock for ADC 34 is delivered from local clock 30. The output digital samples are delivered to an adder 38 which effectively subtracts from each received digital sample (delivered from ADC 34), a corresponding digital sample representative of the transmitted modulated carrier. This removes from the signal detected by hybrid 22, the portion which originated from modem 20, and leaves only the portion sent from the remote model 18. The transmitted samples used by adder 38 are generated in an echo canceller 40 using a conventional transversal adaptive filter based on the output of encoder/modulator 24.

The received, echo cancelled, sample stream delivered by adder 38 (on a line 39) must be demodulated and decoded in a receiver 42 for delivery of the message to DTE 14. The sample stream must be provided to receiver 42 at a sampling rate of say $P/R_x$ (where P is an integer typically the same as N), rather than at the first sampling rate $N/L_x$ of element 38. And the new sample stream must accurately reflect the information contained in the original received sample stream.

The new sample stream (carried on line 45) is generated by a digital asynchronous sample rate converter 44 based on the sample stream on line 39 and on clock phase information about the remote transmission baud rate $l/R_x$. That clock phase information is derived from the new sample stream (in a manner described below) by a timing recovery unit 46 which in turn feeds a second-order digital timing phase-locked loop (PLL) 48. Timing recovery unit 46 is of a known type, for example, as described in Qureshi, United States Patent 4,344,176, issued August 10, 1982, assigned to the same assignee as this application, and incorporated herein by reference. PLL 48 is similar to the kind described in our United States Patent 4,563,657, the disclosure of which is to be regarded as incorporated herein by reference. PLL 48 delivers as an output on line 49 a succession of error values each of which represents the difference between the sampling phase of a given sample on line 39 at the local transmitter sampling rate $N/L_x$ and an optimal sampling phase (at the remote transmitter rate

$P/R_x$).

Referring to Fig. 2, as an example, define $C_i$ as the i-th sample in the input sample stream of converter 44 (on line 39, Fig. 1) and $S_j$ as the j-th sample in the output sample stream (on line 45). Then the stream of samples $C_i$ represents (at rate $N/L_x$) the analog modulated carrier signal originating at the remote modem, and it is desired to have the stream of samples $S_j$ also accurately represent (at rate $P/R_x$) that same analog signal.

Suppose that the rate ($N/L_x$) of the samples $C_i$ is nominally 7/8 the rate ($P/R_x$) of the samples $S_j$. The sampling phase difference between each sample $C_i$ and a corresponding sample $S_j$ can be represented as $d_i$.

The function of converter 44 in the example is to generate samples $S_j$, given samples $C_i$, in such a way that the samples $S_j$ represent the same information as that contained in samples $C_i$ but appear at <u>any</u> desired different sampling rate. Note that each successive sample $S_j$ must have a greater sampling phase offset $d_i$ from the corresponding sample $C_i$, than did the preceding sample $S_{j-1}$ relative to its corresponding sample $C_{i-1}$. Also, note that the sample $S_9$ has a sampling phase offset ($d_8$) relative to $C_9$ that is equal to a full sampling interval $R_x/P$ of samples $S_j$ plus an amount equal to $d_i$ (and is equal to a full sampling interval $L_x/N$ of sample stream $C_i$). Samples of $S_{10}$, $S_{11}$, ... have even larger sampling phase offsets from $C_{10}$, $C_{11}$, ...

Sample rate converter 44 is capable of providing, for each input sample $C_i$, a corresponding output sample $S_j$ with any predetermined sampling phase offset $d_i$ such that $S_j$ represents the information in the corresponding time segment of the original analog line signal. By controlling the successive sampling phase offsets of successive $S_j$s relative to their corresponding $C_i$s, sample rate converter 44 generates the desired output sample stream.

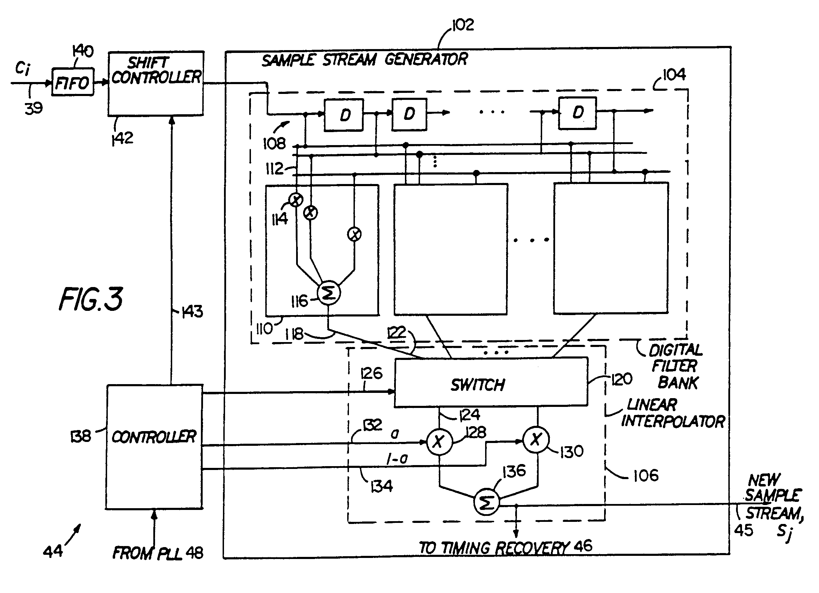

Referring to Fig. 3, sample rate converter 44 includes a sample stream generator 102 whose output is tied to line 45. Sample stream generator 102 has a digital filter bank 104 that feeds a linear interpolator 106 which in turn delivers samples $S_j$ to line 45.

The exact sampling phase position (i.e., position in time) of each output sample $S_j$ is controlled in three stages. A coarse stage positions sample $S_j$ within $2\pi$ -- one full interval $L_x/N$ -- of its desired location. A medium stage positions sample $S_j$ within $2\pi/M$ of its desired location, for M a predetermined integer, e.g., 8. A fine stage positions sample $S_j$ at any desired position within the $2\pi/M$ segment.

To accomplish the medium stage of sampling phase offset, digital filter bank 104 is provided with a Q sample long delay line 108 (e.g., Q = 7) and a set of M digital subfilters 110.

Each subfilter has Q + 1 inputs 112 tied to the respective taps of delay line 108, a set of multipliers 114, and a summer 116. The taps of the delay line are spaced at $L_x/N$ intervals and the m-th subfilter 110 (when selected) uses the sample information at its inputs 112 to generate a single output sample $V_m$ on its output line 118. The sampling phase position of $V_m$ is governed by the coefficients of the multipliers 114 of the m-th subfilter.

As explained below, only two of the subfilters 110 are needed to generate an output sample $S_j$. Thus only two sets of multipliers need to be provided and the two appropriate tap coefficient sets can be fetched from memory for use in the two sets of multipliers. This reduces the implementation complexity.

The coefficients of the m-th subfilter are chosen to give it a frequency response of

$$H_m(f) = A(f) \exp (j(T_o + 2\pi m/N))$$

for m = 0, ..., M - 1, where A(f) is nearly a constant for frequencies between the low and high cut-off frequencies of the received line signal, and $T_o$ is a constant.

Thus the amplitude characteristics of all subfilters are essentially flat in the passband of the line signal and nearly identical one to another. The envelope or group delay characteristic of each subfilter is nearly constant as a function of frequency, but their respective group delay characteristics differ by the same amounts in the passband such that the sampling phase offsets achieved by the M different filters are distributed uniformly at l/M intervals within each input sample interval $L_x/N$.

The coarse stage of sampling phase offset is achieved by the choice of positioning of the input sample sequence in delay line 108, controlled in a manner described below. For a given arrangement of samples in delay line 108, if the output of the m-th filter has a particular sampling phase offset W, then shifting all of the samples one position right in the delay line will cause the output of the m-th filter to have a sampling phase offset of W + $2\pi$.

The fine stage of sampling phase offset is achieved by the linear interpolator 106. Interpolator 106 includes a switch 120 whose M inputs 122 are connected respectively to the outputs 118 of the M subfilters 104. Switch 120 has two outputs 124 and is capable of connecting any two adjacent inputs 122 to its two outputs 124 under control of a signal received over a line 126. (For this purpose, the rightmost and leftmost inputs 122 are considered to be adjacent when considered in conjunction with an appropriate coarse sampling phase adjustment of $2\pi$.)

The outputs 124 feed two conventional multipliers 128, 130, which multiply them respectively by two coefficients (a and 1 - a) supplied over lines 132, 134. The outputs of multipliers 128, 130 are then fed to a summer 136 whose output is connected to line 45.

Linear interpolator 106 thus effectively delivers an output sample $S_j$ having a sampling phase offset whose magnitude is between W and W + $2\pi/M$ (the sampling phase offsets of the two selected subfilters (intermediate) output samples), the exact sampling phase offset being determined by the value of a.

The interpolator introduces some distortion caused by aliasing; however, the amount of distortion introduced in conjunction with even a relatively small number of subfilters (e.g., M = 8) is comparable to the distortion produced by a relatively large number of subfilters (e.g., M = 160) used without a subsequent linear interpolation. Thus the invention greatly reduces the amount of memory required for storing tap coefficients.

The control signals on lines 126, 132, 134 are generated by a controller 138 based on information received from PLL 48 indicating the amount of sampling phase offset required for the next output samples $S_j$.

Controller 138 also sends control signals via a line 143 connected to a shift controller 142, which governs the delivery of samples $C_i$ into delay line 108.

Shift controller 142 is supplied with samples $C_i$ from line 39 via, e.g., a 16 sample long first-in, first-out (FIFO) buffer 140. Samples $C_i$ are clocked into FIFO buffer 140 at the rate $N/L_x$ based on local clock 30 (Fig. 1). Shift controller 142 moves samples out of FIFO buffer 140 and into delay line 108 at intervals specified by controller 138.

Generally, the samples from FIFO 140 are shifted into delay line 108 at rate $P/R_x$. However, when $P/R_x$ differs from $N/L_x$, the shift controller 142 occasionally must skip shifting a sample into the delay line or must shift two samples at once into the delay line. The reason for this can be seen in the fact that on average the rate at which samples are withdrawn from FIFO 140 must be the same as the rate at which they enter FIFO 140, i.e., $N/L_x$. Thus, for example, if $P/R_x > N/L_x$, shift controller 142 must occasionally skip shifting a sample to reduce the average rate at which samples enter the delay line.

Suppose $N/L_x$ is 7/8 of $P/R_x$, as shown in Fig. 2. If the subfilters 110 are arranged such that the left-most (m = 0) subfilter produces no sampling phase offset, the next subfilter (m = 1) produces $2\pi/M$ offset, and so on, then for the first eight input samples $C_i$, the output samples $S_j$ are taken from the subfilters shown in the following table. (Those first eight samples $C_1$-$C_8$ are entered into the delay line at rate $P/R_x$.)

| Input | Output | Phase Shift | Subfilter Used (m) |
|---|---|---|---|
| $C_1$ | $S_1$ | $d_0 = 0$ | 0 |
| $C_2$ | $S_2$ | $d_1 = -2\pi/8$ | 1 |
| $C_3$ | $S_3$ | $d_2 = -4\pi/8$ | 2 |
| $C_4$ | $S_4$ | $d_3 = -6\pi/8$ | 3 |
| $C_5$ | $S_5$ | $d_4 = -8\pi/8$ | 4 |
| $C_6$ | $S_6$ | $d_5 = -10\pi/8$ | 5 |
| $C_7$ | $S_7$ | $d_6 = -12\pi/8$ | 6 |
| $C_8$ | $S_8$ | $d_7 = -14\pi/8$ | 7 |

At this point, shift controller 142 is instructed to skip shifting a sample into the delay line, which in effect produces a $-2\pi$ shift in the outputs of all subfilters. Thus $d_8$, which is $-16\pi/8 = -2\pi$, is achieved by taking the eighth sample from subfilter m = 0, and so on.

Of course, if $P/R_x$ were less than $N/L_x$, the opposite situation would pertain and the subfilters would be used in reverse order with an additional sample being shifted after the lowest order subfilter is used.

When finer increments of sampling phase offset are required, linear interpolation is used and in that case two subfilters must generate intermediate samples to be combined in the interpolator; when larger shifts are required, the subfilters used for successive samples $S_j$ may not be adjacent as they were in the example given above. For very large shifts, a coarse adjustment may also be required.

Controller 138 uses conventional logic (not shown) to coordinate the shift controller 142, the switch 120, and the delivery of coefficients a and 1-a, in order to achieve the proper sampling phase offset for each output sample $S_j$, based on the signals from PLL 48 indicating the needed amount of sampling phase offset. Note that controller 138 is thus not restricted to dealing with only fixed rates $N/L_x$ or $P/R_x$ but can operate adaptively as the sampling phase offset signals generated by PLL 48 vary.

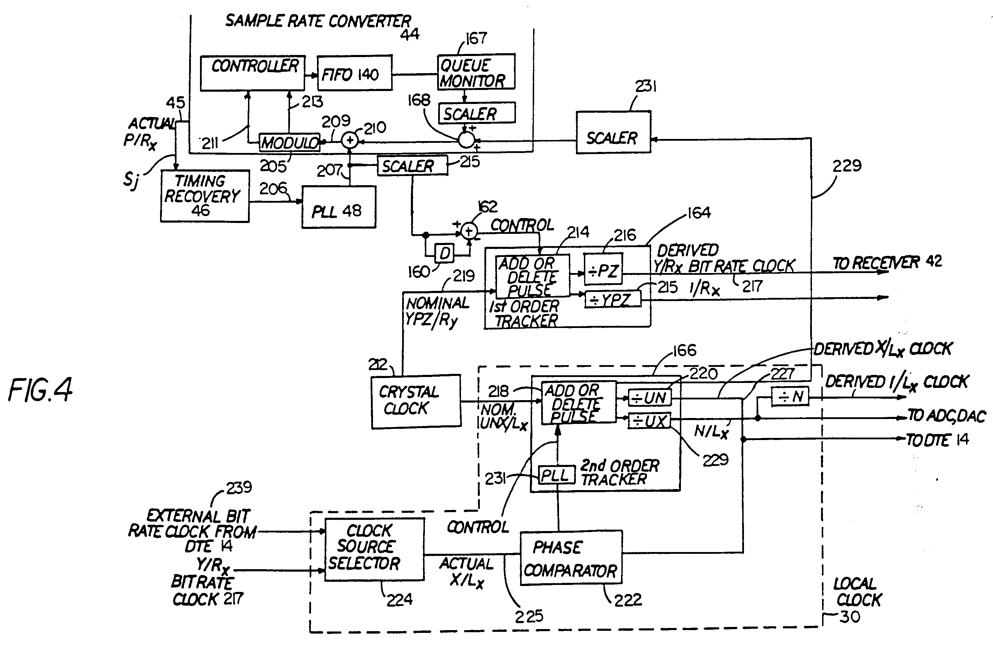

Referring to Fig. 4, timing recovery block 46 receives the output samples $S_j$ (from converter 44) at an actual rate $P(R_x)$ and determines the difference between the actual sampling phase of each sample $S_j$ (on line 45)

and an optimal sampling phase (at rate $P/R_x$) implied in the actual sample sequence $S_j$ and determined by e.g., a maximum band edge energy criterion. Signals representing the phase difference information are delivered on line 206 to PLL 48. When there is no sampling phase difference the output on line 206 is zero; otherwise, it is a value representing the magnitude of the sampling phase error. PLL 48 uses the values on line 206 in generating 15-bit output signals each of which represents the sampling phase offset between the optimal sampling phase (at rate $P/R_x$) and the local actual transmitter sampling phase at rate $N/L_x$. PLL 48 is a second order phase locked loop; therefore even when the input of line 206 is zero, the output value may be increasing or decreasing by regular increments in order to maintain the desired constant rate differential between the rate $P/R_x$ and the rate $N/L_x$. When the input on line 206 is non-zero, the output of PLL 48 will be adjusted to cause a change in the rate differential in order to drive the value on line 206 toward zero. The output of PLL 48 passed to an adder 210 (whose function will be described below) and from there via line 209 to a modulo unit 205. The value on line 209 is expressed as modulo (the local transmitter sampling interval $N/L_x$), i.e., multiples of $2\pi$ are eliminated and only the remaining part of the sampling phase offset -- less than $2\pi$ -- is delivered on line 211 for use by converter 44. As part of the modulo operation 205, for each $2\pi$ amount of sampling phase offset that is eliminated, modulo 205 provides a pulse on line 213 to controller 138 which in turn results in a coarse adjustment signal on line 143 (Fig. 3).

The output of PLL 48 is also passed through a scaler 215 and then both directly, and via a delay element 160, to a summer 162. The output of summer 162 thus represents the <u>change</u> from interval to interval in the amount of sampling phase offset between the samples at rate $N/L_x$ and the optimal sampling phase of the samples $S_j$ at $P/R_x$. A first order tracker 164 uses the output of adder 162 to generate a stable derived bit-rate clock $Y/R_x$ on line 217 ($Y$ is the number of bits per symbol) synchronized to the remote transmitter bit-rate clock using a high-speed stable clock at a nominal rate of $YPZ/R_z$ (generated on line 219 from a crystal clock 212) for use in clocking the samples $S_j$ from receiver 42 to the local DTE 14 (Fig. 1).

To achieve this, first order tracker 164 receives from fixed rate crystal clock 212 pulses at a rate $YPZ$ times the nominal remote transmitter rate $I/R_x$ ($Z$ is an integer). In tracker 164, the clock $YPZ/R_x$ is passed through a block 214 which adds or deletes pulses under control of the output of summer 162. The output of block 214 is passed through a divide-by-$ZP$ element 216 to generate the derived $Y/R_x$ bit rate clock, and is separately passed through a divide-by-$YPZ$ element 215 to generate a derived $I/R_x$ baud rate clock. When the sampling phase offset between the samples at rate $P/R_x$ and the samples at rate $N/L_x$ is not changing, the output of summer 162 is zero, block 214 is not activated, and the derived $Y/R_x$ bit rate clock and $I/R_x$ baud rate clock have fixed frequencies based directly on the crystal clock 212. Otherwise, the output of summer 162 is non-zero and the derived $Y/R_x$ bit rate clock (and $I/R_x$ baud rate clock) is varied to reflect the changes. Thus, the first order tracker uses the information derived from the samples $S_j$ to derive bit rate and baud rate clocks that track the actual remote transmitter bit rate.

If the local transmitter sample rate clock $N/L_x$ 30 (Fig. 1) is stable (e.g., directly derived from a precision crystal oscillator), the arrangement described above will ensure stable operation; sample rate converter 44 will be adjusted automatically to accommodate changes in rate $P/R_x$.

However, if the local transmitter sample rate clock 30 is synchronized with an external clock (e.g., an external bit rate clock 239 from DTE 14) or the derived receiver bit rate clock $Y/R_x$ 217 in a timing loopback scheme (as selected by a clock selector 224), phase jitter or frequency shifts may be introduced into the actual local transmitter bit-rate clock $X/L_x$. Because the samples $S_j$ are derived from the received echo cancelled samples which had been sampled at a rate $N/L_x$ governed by the local transmitter clock 30, the timing changes in clock 30 will also affect the samples $S_j$ which the receiver processes, possibly degrading the performance of the receiver or causing instability in the modem operation.

To reduce the effects of these problems, local clock 30 is provided with a second order timing tracker and phase compensation circuit 166 including a second order PLL 231, an add or delete pulse block 218, and a divide-by-$U$ element 220. One input to tracker 166 is a fixed rate clock (at $UNX$ times the nominal local transmit clock rate $I/L_x$, $U$ an integer) generated by crystal clock 212. One output of tracker 166 is a derived clock $X/L_x$ which tracks the actual $X/L_x$ clock on line 225 but smoothes out jitters and frequency shifts.

To accomplish this, a phase comparator 222 compares the phase of the derived clock on line 227 with the actual clock on line 225 and delivers an error signal to PLL 231. If the error signal is zero, PLL 231 continues to deliver control signals to add or delete 218 to cause the addition or deletion of clock pulses at a rate that keeps the derived clock on line 227 in phase with the actual clock on line 225. If the error signal from phase comparator 222 is non-zero then the PLL output is adjusted to drive the phase of the derived clock toward the phase of the actual clock. The effect of the PLL is to accumulate and smooth the phase error signals from phase comparator 222. Note that the pulses deleted or added in 218 reflect phase changes in the ADC 34 sampling clock (Fig. 1) relative to a nominal stable sample rate clock derived from crystal clock 212, and thus reflects the sampling phase changes in the samples $C_i$. The output of add or delete 218 is delivered to a divide-by-$UN$

EP 0 285 413 B1

element 220 to convert it to a clock at rate $X/L_x$ (for delivery to DTE 14) and is separately divided by UX in element 229 to generate a sample rate clock $N/L_x$ for delivery to ADC 34 and DAC 26 (Fig. 1). The $N/L_x$ clock is further divided by N to generate baud rate clock $I/L_x$. The number of pulses added or deleted by 218 is also sent over line 229, through scaler 231 and via a summer 168 (to be described below) to another summer 210 where it is added to the output of PLL 48. In this way the rate shift accomplished by the controller 138 is adjusted to compensate for jitter and frequency shifts in the non-stable external clock or loopback clock selected by clock source selector 224.

It may prove impossible, even by this arrangement, to maintain an exact synchronism between the locally derived receiver bit-rate clock $Y/R_x$ on line 217 (which is synchronized with the rate of the rate converter that generates the $S_j$'s) and the actual remote transmitter bit-rate clock $Y/R_x$ on line 45; in that case the FIFO buffer 140 will, over time, tend to become empty or full. To prevent either situation, and to maintain a medium level of occupancy of FIFO 140, a FIFO queue monitor 167 senses the occupancy level of the FIFO. When the occupancy is consistently above or below the medium level, it issues a value which is added in adder 168 to the output of tracker 166 thereby causing an adjustment of the output of PLL 48 via summer 210. This also effectively corrects the phase of the locally derived $Y/R_x$ clock via timing recovery 46, PLL 48, and scaler 215. The timing corrections made by monitor 167 are assumed to be small over the time lengths of interest. For example, if the variation of the local transmitter clock period $L_x$ is on the order of microseconds, the number of samples in FIFO buffer 140 will shrink or grow noticeably only after a time on the order of ten seconds. Monitor 167 checks the FIFO buffer 140, e.g., every ten seconds. If the number of samples in buffer 140 has grown or shrunk, monitor 167 asserts a signal via adder 168 which affects the operation of controller 138 accordingly.

In the case of loopback timing, the derived $Y/R_x$ clock is returned through the clock source selector 224 to phase comparator 22 in order to control the local transmitter clock. Thus, for example, if FIFO 140 is becoming too full, the resulting increase in the rate Y/Rx (designed to empty the FIFO faster) will also cause an increase in the local transmitter clock, causing an increase in the rate at which samples are loaded into the FIFO (and thus, by positive feedback, defeating the desired goal). To prevent possible instability the output of the queue moitor is added to the output of PLL 48, rather than directly to the derived Y/Rx bit rate clock (thus forming a negative feedback loop). This has the disadvantage of disturbing what may otherwise be a stable output of PLL 48, but because the adjustments by the queue monitor are small and infrequent, the disturbance is not a problem.

Thus, the timing adjustments due to transmitter bit rate clock $X/L_x$ jitter (on line 229) and derived bit rate $Y/R_x$ clock asynchronism (represented by the output of queue monitor 167) are combined by adder 168 and applied against the output of PLL 48 in summer 210.

The rate converter 44, queue monitor 167, PLL 48, and trackers 164, 166 may be implemented by programming two cooperating microprocessors that are also used to perform other modem functions and are configured in the manner described in our European Patent Application No. 85301542.8 (Publication No. EP-A-0154551) the disclosure of which is to be regarded as incorporated herein by reference.

The ability of the converter 44 to shift the sampling phase of a sample by any amount enables the sampling phase to be set at an optimal value, thus reducing timing phase acquisition time (when incorporated with an accurate timing phase estimation scheme), reducing turn-around time, and increasing throughout, for example, when applied to a two-wire half-duplex modem.

Other arrangements are feasible. For example, the converter 44 could be used with modems having two or more channels of received signals at different signalling rates.

## Claims

1. Apparatus adapted to receive an input stream of samples representative of a time-varying signal and to generate a corresponding output stream of samples which is also representative of said time-varying signal and in which each output stream sample appears at a desired time which may differ from the time when a sample appears in said input stream, the apparatus being characterised in comprising filter circuitry adapted to receive said input stream and operatively to generate at least two intermediate samples which appear at different times, and interpolation circuitry adapted to combine selected said intermediate samples to form a sample of said output stream at said desired time, further characterised in that said input sample stream is operatively sampled based on a clock derived from an unstable clock having a nominally fixed rate subject to jitter and frequency shifts, in that said output stream operatively appears at a nominally fixed rate, and in that said intermediate samples are adapted operatively to be selected and said interpolation circuitry is adapted operatively to be controlled in response to the difference between the sampling phase of said input stream and the sampling phase of said output stream, said ap-

7

paratus further comprising means for reducing said jitter and frequency shifts in said unstable clock.

2. Apparatus according to claim 1, further characterised in that said filter circuitry comprises a plurality of transversal filters adapted for operatively generating said intermediate sample simultaneously using two or more different said sets of coefficients.

3. Apparatus according to claims 1 or 2, further characterised in that each said set is chosen to be substantially flat in the frequency band represented by the time-varying signal and to have an envelope delay characteristic that differs from the envelope delay characteristics of another set by an amount which is nearly constant as a function of frequency within the passband.

4. Apparatus according to any preceding claim, further characterised in that said interpolation circuitry comprises a switch for selecting two said intermediate samples, and combining circuitry adapted for operatively performing a linear interpolation between said two intermediate samples.

5. Apparatus according to claim 4, further characterised in that the coefficients for said linear interpolation are based on a measure of the difference between the sampling phase of said input stream and the sampling phase of said output stream.

6. Apparatus according to any preceding claim, further characterised in that said output stream has a sample rate that differs from the sample rate of said input stream.

7. Apparatus according to claim 6, further characterised in that said apparatus comprises a modem adapted to be operatively coupled to a line signal, said input stream comprising a stream of samples derived by said modem from said line signal, and said output stream comprising a stream of samples used by said modem to derive data carried by said line signal.

8. Apparatus according to claim 7, further characterised in that said modem is a full-duplex, echo cancellation modem, said input sample stream appears at a rate related to the transmission baud rate of said modem, and said output stream appears at a rate operatively related to the transmission baud rate of a modem at the other end of said line.

9. Apparatus according to any of claims 6, 7 or 8, further characterised in that the sampling phase difference between samples of said input stream and samples of said output stream varies over time, and further comprising means for selecting said intermediate samples and controlling said interpolation circuitry based on said varying difference.

10. Apparatus according to any preceding claim, further characterised in comprising a buffer adapted for temporarily storing said input stream samples for delivery to said filter circuitry, said samples being operatively stored in said buffer at a first rate which is derived indirectly from an external clock, said samples being operatively accepted by said filter circuitry at a possibly different average second rate based on an external clock, said apparatus further comprising a monitor adapted for monitoring the occupancy status of said buffer and for operatively causing said average second rate to be adjusted so that said buffer is normally not full or empty.

11. Apparatus according to claim 10, further characterised in that said apparatus comprises a modem adapted to be operatively coupled to a line signal, said input sample stream comprising samples of said line signal, in that said external clock corresponds to a baud rate of transmission on said line, and in that said second rate is a clock corresponding to said baud rate and operatively derived locally by said modem.

12. A modem in which a line signal is arranged operatively to be sampled at times governed by an unstable clock, whereby operatively to generate a first sample stream in which the samples appear with possibly changing sampling phases, and in which a converter is arranged operatively to convert the first sample stream to a second stream of samples appearing at times that are possibly different from the times of appearance of the samples in the first sample stream, characterised in comprising signal means adapted for operatively providing to said converter signals representative of the changing sampling phases in the first sample stream, whereby operatively to cause said conversion to occur in a manner that reduces the contribution of said changing sampling phases to the times of appearance of the samples in said second sample stream utilising a dynamic interpolation scheme.

13. A modem according to claim 12, further characterised in that said unstable clock is operatively provided from a data terminal equipment associated with said modem.

14. A modem according to claim 12, further characterised in that said unstable clock is a clock operatively derived from said second sample stream.

15. A modem according to claim 12, further characterised in comprising a stable clock adapted operatively to deliver pulses at a nominal rate related to the rate of pulses of said unstable clock, and in that said signal means comprises means adapted operatively to generate said signals based on detecting changes in phase of said unstable clock pulses relative to the pulses of said stable clock.

16. A modem according to claim 15, further characterised in that said signal means includes an add or delete pulse circuit adapted for operatively generating a derived clock from said stable clock by adding or deleting pulses to or from said stable clock, and a comparator adapted from operatively generating comparisons of the phases of said unstable clock pulses with the phases of pulses or said derived clock, said add or delete pulse circuit being adapted to operate in response to said comparisons.

17. A modem according to any of claims 12 to 16, further characterised in that said converter comprises conversion circuitry and a buffer adapted for temporarily storing samples of said first sample stream for delivery to said conversion circuitry, said samples being arranged operatively to be stored in a said buffer at a first rate derived from said unstable clock, in that said conversion circuitry is adapted to accept said samples at a possibly different second rate based on said signals provided to said converter, and in that a monitor is provided for operatively monitoring the occupancy status of said buffer and for operatively causing said first rate to be adjusted so that said buffer is normally not empty or full.

18. A modem according to any of claims 12 to 16, wherein said first sample stream represents a time-varying signal, said second sample stream is also representative of said time-varying signal, and each second stream sample appears at a desired time, further characterised in that said converter comprises filter circuitry adapted operatively to receive said first stream and to generate at least two intermediate samples which appear at different times, and interpolation circuitry adapted to combine selected intermediate samples to form a sample of said second stream at said desired time.

19. A method for generating an output stream of sample from an input stream of samples representative of a time-varying signal, output stream of samples also being representative of said time-varying signal, the and each output stream sample appearing at a desired time which may differ from the time when a sample appears in said input stream, the method being characterised in comprising the steps of receiving said input stream and generating, by filtering, at least two intermediate samples which appear at different times, and interpolating selected said intermediate samples to form a sample of said output stream at said desired time.

20. A method of operating a modem in which a line signal is sampled at times governed by an unstable clock to generate a first sample stream in which the samples appear with possibly changing phases and a converter converts the first sample stream to a second stream of samples appearing at times that are possibly different from the times of appearance to the samples in the first sample stream, the method being characterised in comprising providing to said converter signals representative of the changing sampling phases of the samples in the first sample stream, whereby to cause said conversion to occur in a manner that reduces the contribution of said changing sampling phases to the times of appearance of the samples in said second sample stream utilising a dynamic interpolation scheme.

## Patentansprüche

1. Vorrichtung, die einen Eingangsstrom von Abtastwerten empfängt, der für ein zeitveränderliches Signal steht, und einen entsprechenden Ausgangsstrom von Abtastwerten erzeugt, der ebenfalls für das zeitveränderliche Signal steht, wobei jeder Ausgangsstrom-Abtastwert zu einem gewünschten Zeitpunkt auftritt, der sich von dem Zeitpunkt unterscheiden kann, zu dem ein Abtastwert in dem Eingangsstrom auftritt, wobei die Vorrichtung **dadurch gekennzeichnet** ist, daß sie eine Filterschaltung umfaßt, die den Eingangsstrom empfängt und in Funktion wenigstens zwei Abtastwerte erzeugt, die zu unterschiedlichen Zeitpunkten auftreten, sowie eine Interpolationsschaltung, die ausgewählte der Zwischen-Abtastwerte kombiniert und einen Abtastwert des Ausgangsstroms zu dem gewünschten Zeitpunkt erzeugt, des weiteren **dadurch gekennzeichnet**, daß der Eingangs-Abtastwertstrom in Funktion auf der Grundlage eines Taktes abgetastet wird, der aus einem instabilen Takt mit einer nominell festen Frequenz hergeleitet wird, die Jitter und Frequenzverschiebungen ausgesetzt ist, dadurch, daß der Ausgangsstrom in Funktion mit einer nominell festen Frequenz auftritt, und dadurch, daß die Zwischen-Abtastwerte in Funktion ausgewählt werden und die Interpolationsschaltung in Funktion in Reaktion auf den Unterschied zwischen der Abtastphase des Eingangsstroms und der Abtastphase des Ausgangsstroms gesteuert wird, wobei die Vorrichtung des weiteren eine Einrichtung zum Verringern des Jitters und der Frequenzverschiebungen des instabilen Taktes umfaßt.

2. Vorrichtung nach Anspruch 1, des weiteren **dadurch gekennzeichnet**, daß die Filterschaltung eine Vielzahl von Transversalfiltern umfaßt, die in Funktion den Zwischen-Abtastwert erzeugen und dabei gleichzeitig zwei oder mehr unterschiedliche der Gruppen von Koeffizienten benutzen.

3. Vorrichtung nach Anspruch 1 oder 2, des weiteren **dadurch gekennzeichnet**, daß jede Gruppe so ausgewählt wird, daß sie in dem durch das zeitveränderliche Signal dargestellten Frequenzband im wesentlichen flach ist und eine Gruppenlaufzeitkennlinie aufweist, die sich von den Gruppenlaufzeitkennlinien einer weiteren Gruppe um einen Betrag unterscheidet, der als eine Funktion der Frequenz im Durchlaßbereich nahezu konstant ist.

4. Vorrichtung nach einem der vorangehenden Ansprüche, des weiteren **dadurch gekennzeichnet**, daß die Interpolationsschaltung einen Schalter umfaßt, der zwei der Zwischen-Abtastwerte auswählt, und eine Kombinationsschaltung, die in Funktion eine lineare Interpolation zwischen den beiden Zwischen-Abtastwerten ausführt.

5. Vorrichtung nach Anspruch 4, des weiteren **dadurch gekennzeichnet**, daß die Koeffizienten für die lineare Interpolation auf einem Maß der Differenz zwischen der Abtastphase des Eingangsstroms und der Abtastphase des Ausgangsstroms beruhen.

6. Vorrichtung nach einem der vorangehenden Ansprüche, des weiteren **dadurch gekennzeichnet**, daß der Ausgangsstrom eine Abtastrate aufweist, die sich von der Abtastrate des Eingangsstroms unterscheidet.

7. Vorrichtung nach Anspruch 6, des weiteren **dadurch gekennzeichnet**, daß die Vorrichtung ein Modem umfaßt, das in Funktion mit einem Leitungssignal verbunden wird, wobei der Eingangsstrom einen Strom von Abtastwerten umfaßt, der durch das Modem aus dem Leitungssignal hergeleitet wird, und der Ausgangsstrom einen Strom von Abtastwerten umfaßt, die durch das Modem benutzt werden, um von dem Leitungssignal übertragene Daten herzuleiten.

8. Vorrichtung nach Anspruch 7, des weiteren **dadurch gekennzeichnet**, daß das Modem ein Gegenschreib-Echounterdrükkungs-Modem ist, der Eingangs-Abtastwertstrom mit einer Rate auftritt, die im Verhältnis zur Übertragungs-Baud-Rate des Modems steht, und der Ausgangsstrom mit einer Rate auftritt, die in Funktion im Verhältnis zur Übertragungs-Baud-Rate am anderen Ende der Leitung steht.

9. Vorrichtung nach einem der Ansprüche 6, 7 oder 8, des weiteren **dadurch gekennzeichnet**, daß der Abtastphasenunterschied zwischen den Abtastwerten des Eingangsstroms und den Abtastwerten des Ausgangsstroms sich zeitlich verändert, und die des weiteren eine Einrichtung umfaßt, die auf der Grundlage des sich ändernden Unterschiedes die Zwischen-Abtastwerte auswählt und die Interpolationsschaltung steuert.

10. Vorrichtung nach einem der vorangehenden Ansprüche, des weiteren **dadurch gekennzeichnet**, daß sie einen Pufferspeicher umfaßt, der die Eingangsstrom-Abtastwerte zeitweilig speichert und sie der Filterschaltung zuführt, wobei die Abtastwerte in dem Pufferspeicher in Funktion mit einer ersten Rate gespeichert werden, die indirekt aus einem externen Takt hergeleitet wird, wobei die Abtastwerte durch die Filterschaltung in Funktion bei einer möglicherweise anderen durchschnittlichen zweiten Rate angenommen werden, die auf einem externen Takt beruht, wobei die Vorrichtung des weiteren eine Überwachungseinrichtung umfaßt, die den Belegungszustand des Pufferspeichers überwacht und in Funktion bewirkt, daß die durchschnittliche zweite Rate so reguliert wird, daß der Pufferspeicher normalerweise nicht voll oder leer ist.

11. Vorrichtung nach Anspruch 10, des weiteren **dadurch gekennzeichnet**, daß die Vorrichtung ein Modem umfaßt, das in Funktion mit einem Leitungssignal verbunden werden kann, wobei der Eingangs-Abtastwertstrom Abtastwerte des Leitungssignals umfaßt, dadurch, daß der externe Takt einer Baud-Rate der Übertragung über die Leitung entspricht, und daß die zweite Rate ein Takt ist, der der Baud-Rate entspricht und in Funktion lokal durch das Modem hergeleitet wird.

12. Modem, bei dem ein Leitungssignal in Funktion zu Zeitpunkten abgetastet wird, die durch einen instabilen Takt gesteuert werden, so daß in Funktion ein erster Abtastwertstrom erzeugt wird, in dem die Abtastwerte mit möglicherweise veränderlichen Abtastphasen auftreten, und bei dem ein Wandler den ersten Abtastwertstrom in Funktion in einen zweiten Strom von Abtastwerten umwandelt, die zu Zeitpunkten auftreten, die sich möglicherweise von den Zeitpunkten des Auftretens der Abtastwerte in dem ersten Abtastwertstrom unterscheiden, **dadurch gekennzeichnet**, daß es eine Signaleinrichtung umfaßt, die in Funktion die Wandlersignale erzeugt, die für die veränderlichen Abtastphasen in dem ersten Abtastwertstrom stehen, so daß in Funktion bewirkt wird, daß die Umwandlung so abläuft, daß der Beitrag der veränderlichen Abtastphasen zu den Zeitpunkten des Auftretens der Abtastwerte in dem zweiten Abtastwertstrom unter Verwendung eines dynamischen Interpolationsschemas verringert wird.

13. Modem nach Anspruch 12, des weiteren **dadurch gekennzeichnet**, daß der instabile Takt in Funktion von einer Datenendeinrichtung erzeugt wird, die mit dem Modem verbunden ist.

14. Modem nach Anspruch 12, des weiteren **dadurch gekennzeichnet**, daß der instabile Takt ein Takt ist, der in Funktion aus dem zweiten Abtastwertstrom hergeleitet wird.

15. Modem nach Anspruch 12, des weiteren **dadurch gekennzeichnet**, daß es einen stabilen Takt umfaßt, der in Funktion Impulse mit einer nominellen Rate abgibt, die im Verhältnis zur Rate von Impulsen des instabilen Taktes steht, und dadurch, daß die Signaleinrichtung eine Einrichtung umfaßt, die in Funktion die Signale auf der Grundlage der Erfassung von Phasenveränderungen der instabilen Taktimpulse im Verhältnis zu den Pulsen des stabilen Taktes erzeugt.

16. Modem nach Anspruch 15, des weiteren **dadurch gekennzeichnet**, daß die Signaleinrichtung eine Addier- oder Ausschlußimpuls-Schaltung enthält, die in Funktion einen hergeleiteten Takt aus dem stabilen Takt erzeugt, indem Impulse zu dem stabilen Takt addiert oder daraus ausgeschlossen werden, sowie einen Komparator, der in Funktion Vergleiche der Phasen der instabilen Taktimpulse mit den Phasen der Impulse des hergeleiteten Taktes anstellt, wobei die Addier- oder Ausschlußimpuls-Schaltung in Reaktion auf die Vergleiche arbeitet.

17. Modem nach einem der Ansprüche 12 bis 16, des weiteren **dadurch gekennzeichnet**, daß der Wandler eine Umwandlungsschaltung und einen Pufferspeicher umfaßt, der Abtastwerte des ersten Abtastwertstroms zeitweilig speichert und sie der Umwandlungsschaltung zuführt, wobei die Abtastwerte in dem Pufferspeicher in Funktion mit einer ersten Rate gespeichert werden, die aus dem instabilen Takt hergeleitet wird, dadurch, daß die Umwandlungsschaltung die Abtastwerte mit einer möglicherweise anderen zweiten Rate annimmt, die auf den Signalen beruht, die dem Wandler zugeführt werden, und dadurch, daß eine Überwachungseinrichtung vorhanden ist, die den Belegungsstatus des Pufferspeichers in Funktion überwacht und in Funktion bewirkt, daß die erste Rate so reguliert wird, daß der Pufferspeicher normalerweise nicht leer oder voll ist.

18. Modem nach einem der Ansprüche 12 bis 16, wobei der erste Abtastwertstrom für ein zeitveränderliches Signal steht, der zweite Abtastwertstrom ebenfalls für das zeitveränderliche Signal steht, und jeder Abtastwert des zweiten Stroms zu einem gewünschten Zeitpunkt auftritt, des weiteren **dadurch gekennzeichnet**, daß der Wandler eine Filterschaltung umfaßt, die in Funktion den ersten Strom empfängt und wenigstens zwei Zwischen-Abtastwerte erzeugt, die zu unterschiedlichen Zeitpunkten auftreten, sowie Interpolationsschaltung, die ausgewählte ZwischenAbtastwerte kombiniert und einen Abtastwert des zweiten Stroms zu dem gewünschten Zeitpunkt erzeugt.

19. Verfahren zum Erzeugen eines Ausgangsstroms von Abtastwerten aus einem Eingangsstrom von Abtastwerten, der für ein zeitveränderliches Signal steht, wobei der Ausgangsstrom von Abtastwerten ebenfalls für das zeitveränderliche Signal steht, wobei der und jeder Ausgangsstrom-Abtastwert zu einem gewünschten Zeitpunkt auftritt, der sich von dem Zeitpunkt unterscheiden kann, zu dem ein Abtastwert in dem Eingangsstrom auftritt, wobei das Verfahren **dadurch gekennzeichnet** ist, daß es die Schritte des Empfangens des Eingangsstroms und des Erzeugens von wenigstens zwei Zwischen-Abtastwerten, die zu unterschiedlichen Zeitpunkten auftreten, durch Filtern, sowie des Interpolierens ausgewählter der Zwischen-Abtastwerte umfaßt, um einen Abtastwert des Ausgangsstroms zu dem gewünschten Zeitpunkt zu erzeugen.

20. Verfahren zum Betreiben eines Modems, wobei ein Leitungssignal zu Zeitpunkten abgetastet wird, die durch einen instabilen Takt bestimmt werden, um einen ersten Abtastwertstrom zu erzeugen, in dem die Abtastwerte mit möglicherweise veränderlichen Phasen auftreten, und ein Wandler den ersten Abtastwertstrom in einen zweiten Strom von Abtastwerten umwandelt, die zu Zeitpunkten auftreten, die sich möglicherweise von den Zeitpunkten des Auftretens der Abtastwerte in dem ersten Abtastwertstrom unterscheiden, wobei das Verfahren **dadurch gekennzeichnet** ist, daß es das Erzeugen der Wandlersignale umfaßt, die für die veränderlichen Abtastphasen der Abtastwerte in dem ersten Abtastwertstrom stehen, so daß die Umwandlung so abläuft, daß der Beitrag der veränderlichen Abtastphasen zu den Zeitpunkten des Auftretens der Abtastwerte in dem zweiten Abtastwertstrom unter Verwendung eines dynamischen Interpolationsschemas verringert wird.

**Revendications**

1. Appareil conçu pour recevoir un flux d'échantillons d'entrée représentatif d'un signal variant avec le temps et pour générer un flux d'échantillons de sortie correspondant qui est également représentatif dudit signal variant avec le temps et dans lequel chaque échantillon du flux de sortie apparaît à un moment souhaité qui peut différer du moment d'apparition d'un échantillon dans ledit flux d'entrée, l'appareil étant caractérisé en ce qu'il comprend des circuits de filtrage conçus pour recevoir ledit flux d'entrée et, en fonctionnement, pour générer au moins deux échantillons intermédiaires qui apparaissent à des moments différents, et des circuits d'interpolation conçus pour combiner lesdits échantillons intermédiaires sélectionnés pour former un échantillon dudit flux de sortie audit moment souhaité, caractérisé, de plus, en ce que ledit flux d'échantillons d'entrée est échantillonné, en fonctionnement, à partir d'une horloge dérivée d'une horloge instable présentant une fréquence nominalement fixe soumise à une instabilité et à des glissements de fréquences, en ce que ledit flux de sortie apparaît, en fonctionnement, à une fréquence nominalement fixe, et en ce que lesdits échantillons intermédiaires sont conçus, en fonctionnement, pour être sélectionnés et que ledit circuit d'interpolation est conçu, en fonctionnement, pour être contrôlé, en réponse à la différence entre la phase d'échantillonnage dudit flux d'entrée et la phase d'échantillonnage dudit flux de sortie, ledit appareil comprenant, en outre, un moyen pour réduire ladite instabilité et lesdits glissements de fréquences dans ladite horloge instable.

2. Appareil selon la revendication 1, caractérisé, de plus, en ce que lesdits circuits de filtrage comprennent une pluralité de filtres transversaux conçus pour générer, en fonctionnement, ledit échantillon intermédiaire simultanément à l'utilisation de deux ensembles de coefficients différents ou plus.

3. Appareil selon la revendication 1 ou 2, caractérisé, de plus, en ce que ledit ensemble est choisi pour être sensiblement uniforme dans la bande de fréquences représentée par le signal variant avec le temps et pour avoir une caractéristique de retard d'enveloppe qui diffère des caractéristiques de retard d'enveloppe d'un autre ensemble d'une valeur qui est pratiquement constante en fonction de la fréquence de la bande passante.

4. Appareil selon l'une quelconque des revendications précédentes, caractérisé, de plus, en ce que lesdits circuits d'interpolation comprennent un commutateur pour sélectionner deux dits échantillons intermédiaires , et pour combiner des circuits conçus pour réaliser, en fonctionnement, une interpolation linéaire entre lesdits deux échantillons intermédiaires.

5. Appareil selon la revendication 4, caractérisé, de plus, en ce que les coefficients de ladite interpolation sont basés sur une mesure de la différence entre la phase d'échantillonnage dudit flux d'entrée et la phase d'échantillonnage dudit flux de sortie.

6. Appareil selon l'une quelconque des revendications précédentes, caractérisé, de plus, en ce que ledit flux de sortie présente une fréquence d'échantillonnage qui diffère de la fréquence d'échantillonnage dudit flux d'entrée.

7. Appareil selon la revendication 6, caractérisé, de plus, en ce que ledit appareil comprend un modem conçu pour être couplé, en fonctionnement, à un signal d'appel, ledit flux d'entrée comprenant un flux d'échantillons dérivé par ledit modem à partir dudit signal d'appel, et ledit flux de sortie comprenant un flux d'échantillons utilisé par ledit modem pour dériver des données acheminées par ledit signal d'appel.

8. Appareil selon la revendication 7, caractérisé, de plus, en ce que ledit modem est un modem à suppression d'écho, à duplex intégral, ledit flux d'échantillons d'entrée apparaissant à une fréquence associée au débit de transmission dudit modem, et ledit flux de sortie apparaissant à une fréquence, en fonctionnement, associée au débit de transmission d'un modem placé à l'autre extrémité de ladite ligne.

9. Appareil selon l'une quelconque des revendications 6, 7, ou 8, caractérisé, de plus, en ce que la différence de phase d'échantillonnage entre les échantillons dudit flux d'entrée et les échantillons dudit flux de sortie varie avec le temps et, de plus, en ce qu'il comprend un moyen pour sélectionner lesdits échantillons intermédiaires et contrôler lesdits circuits d'interpolation en fonction de ladite variation de différence.

10. Appareil selon l'une quelconque des revendications précédentes, caractérisé, de plus, en ce qu'il comprend un tampon conçu pour stocker temporairement lesdits échantillons du flux d'entrée pour les fournir auxdits circuits de filtrage, lesdits échantillons étant stockés, en fonctionnement, dans ledit tampon à une première fréquence qui est dérivée indirectement d'une horloge extérieure, lesdits échantillons étant acceptés, en fonctionnement, par lesdit circuits de filtrage à une deuxième fréquence moyenne éventuellement différente basée sur une horloge extérieure, ledit appareil comprenant, de plus, un contrôleur conçu pour contrôler l'état d'occupation dudit tampon et pour permettre l'ajustement, en fonctionnement, de ladite deuxième fréquence moyenne pour que ledit tampon soit normalement non plein ou vide.

11. Appareil selon la revendication 10, caractérisé, de plus, en ce que ledit appareil comprend un modem conçu pour être couplé, en fonctionnement, à un signal d'appel, ledit flux d'échantillons d'entrée comprenant des échantillons dudit signal d'appel, en ce que ladite horloge extérieure correspond à un débit de transmission sur ladite ligne, et en ce que ladite deuxième fréquence est une horloge correspondant audit débit de transmission et dérivée, en fonctionnement, localement par ledit modem.

12. Modem dans lequel un signal d'appel est agencé, en fonctionnement, pour être échantillonné à des moments régis par une horloge instable, de manière à générer, en fonctionnement, un premier flux d'échantillons dans lequel les échantillons apparaissent avec des phases d'échantillonnage éventuellement changeantes, et dans lequel un convertisseur est agencé, en fonctionnement, pour convertir le premier flux d'échantillons en un deuxième flux d'échantillons apparaissant à des moments qui sont éventuellement différents des moments d'apparition des échantillons dans le premier flux d'échantillons, caractérisé en ce qu'il comprend un moyen de transmission conçu pour fournir, en fonctionnement, audit convertisseur des signaux représentatifs des phases d'échantillonnage changeantes dans le premier flux d'échantillons, de façon à permettre, en fonctionnement, ladite conversion de manière à réduire la contribution desdites phases d'échantillonnage changeantes aux moments d'apparition des échantillons dans ledit deuxième flux d'échantillons utilisant un circuit d'interpolation dynamique.

13. Modem selon la revendication 12, caractérisé, de plus, en ce que ladite horloge instable est équipée, en fonctionnement, d'un équipement terminal de traitement de données associé audit modem.

14. Modem selon la revendication 12, caractérisé, de plus, en ce que ladite horloge instable est une horloge dérivée, en fonctionnement, dudit deuxième flux d'échantillons.

15. Modem selon la revendication 12, caractérisé, de plus, en ce qu'il comprend une horloge stable conçue, en fonctionnement, pour délivrer des impulsions à une fréquence nominale associée à la fréquence d'impulsions de ladite horloge instable, et en ce que ledit moyen de transmission comprend un moyen conçu, en fonctionnement, pour générer lesdits signaux à partir de la détection de changements de phase desdites impulsions de l'horloge instable par rapport aux impulsions de ladite horloge stable.

16. Modem selon la revendication 15, caractérisé, de plus, en ce que ledit moyen de transmission comprend un circuit d'impulsions d'addition ou de suppression conçu pour générer, en fonctionnement, une horloge dérivée de ladite horloge stable en ajoutant ou en supprimant des impulsions à ou de ladite horloge stable, et un comparateur conçu à partir de la génération, en fonctionnement, de comparaisons des phases des impulsions de ladite horloge instable avec les phases d'impulsions de ladite horloge dérivée, ledit circuit d'impulsions d'addition ou de suppression étant conçu pour fonctionner en réponse auxdites comparaisons.

17. Modem selon l'une quelconque des revendications 12 à 16, caractérisé, de plus, en ce que ledit convertisseur comprend des circuits de conversion et un tampon conçus pour stocker temporairement des échantillons dudit premier flux d'échantillons pour les délivrer audit circuit de conversion, lesdits échantillons étant agencés, en fonctionnement, pour être stockés dans un dit tampon à une première fréquence dérivée de ladite horloge instable, en ce que ledit circuit de conversion est conçu pour accepter lesdits échantillons à une deuxième fréquence éventuellement différente à partir desdits signaux fournis audit convertisseur, et en ce qu'un contrôleur est prévu pour contrôler, en fonctionnement, l'état d'occupation dudit tampon et pour permettre l'ajustement, en fonctionnement, de ladite première fréquence pour que ledit tampon soit normalement non vide ou plein.

18. Modem selon l'une quelconque des revendications 12 à 16, dans lequel ledit premier flux d'échantillons représente un signal variant avec le temps, ledit deuxième flux d'échantillons est également représentatif dudit signal variant avec le temps, et chaque échantillon du deuxième flux apparaît à un moment souhaité, caractérisé, de plus, en ce que ledit convertisseur comprend des circuits de filtrage conçus, en fonctionnement, pour recevoir ledit premier flux et pour générer au moins deux échantillons intermédiaires qui apparaissent à différents moments, et des circuits d'interpolation conçus pour combiner des échantillons intermédiaires sélectionnés pour former un échantillon dudit deuxième flux audit moment souhaité.

19. Procédé pour générer un flux d'échantillons de sortie à partir d'un flux d'échantillons d'entrée représentatif d'un signal variant avec le temps, le flux d'échantillons de sortie étant également représentatif dudit signal variant avec le temps, l'échantillon et chaque échantillon du flux de sortie apparaissant à un moment souhaité qui peut différer du moment d'apparition d'un échantillon dans ledit flux d'entrée, le procédé étant caractérisé en ce qu'il comprend les étapes de réception dudit flux d'entrée et de génération, par filtrage, d'au moins deux échantillons intermédiaires qui apparaissent à différents moments, et d'interpolation desdits échantillons intermédiaires sélectionnés pour former un échantillon dudit flux de sortie audit moment souhaité.

20. Procédé de fonctionnement d'un modem dans lequel un signal d'appel est échantillonné à des moments régis par une horloge instable pour générer un premier flux d'échantillons dans lequel les échantillons apparaissent avec des changements de phases possibles et dans lequel un convertisseur convertit le premier flux d'échantillons en un deuxième flux d'échantillons apparaissant à des moments qui sont éventuellement différents des moments d'apparition des échantillons du premier flux d'échantillons, le procédé étant caractérisé en ce qu'il comprend la fourniture audit convertisseur de signaux représentatifs des changements de phases d'échantillonnage des échantillons du premier flux d'échantillons, de façon à permettre ladite conversion d'une manière qui réduise la contribution dudit changement des phases d'échantillonnage aux moments d'apparition des échantillons dans ledit deuxième flux d'échantillons en utilisant des circuits d'interpolation dynamique.

FIG.3

*SAMPLE STREAM GENERATOR* (102)

*SHIFT CONTROLLER* (142)

*CONTROLLER* (138)

*DIGITAL FILTER BANK*

*LINEAR INTERPOLATOR*

*SWITCH* (120)

*NEW SAMPLE STREAM,* (45) $S_j$

*TO TIMING RECOVERY* 46

*FROM PLL* 48

EP 0 285 413 B1

FIG.4